# EUROPEAN PATENT APPLICATION

(11) **EP 4 790 437 A1**
(43) Date of publication of application: **12.08.2026**
(21) Application number: 26154305.2
(22) Date of filing: 27.01.2026
(51) Int. Cl.: G01R 31/367, G01R 31/382, G01R 31/392

(54) **ELECTRONIC DEVICE AND METHOD WITH BATTERY STATE ESTIMATION**

(30) Priority: 06.02.2025 KR 20250015447
(71) Applicant: Samsung Electronics Co., Ltd., Suwon-si, Gyeonggi-do 16677 (KR)
(72) Inventor: SONG, Tae Won, 16677 Suwon-si, Gyeonggi-do (KR); KIM, Jinho, 16677 Suwon-si, Gyeonggi-do (KR)
(74) Representative: Kuhnen & Wacker Patent- und Rechtsanwaltsbüro PartG mbB

(57) **Abstract**

An electronic device (1500) comprises: a battery (1520); one or more processors (1540); and a memory (1530) storing instructions, which, when executed by the one or more processors (1540), cause the electronic device (1500) to: store an updated parameter value of at least one target parameter selected from among a plurality of degradation parameters based on monitoring of the battery (1520); determine parameter values of the other parameters based on the updated parameter value of the at least one target parameter; estimate a battery state of the battery (1520) based on the updated parameter value of the at least one target parameter and the determined parameter values of the other parameters, using a battery state estimation model; update the parameter values of the other parameters based on the estimated battery state; and determine an updated battery state based on the updated parameter value of the at least one target parameter and the updated parameter values of the other parameters.

## Description

### BACKGROUND

### 1. Field

The following description relates to an electronic device with battery state estimation.

### 2. Description of Related Art

Conventional battery state estimation algorithms typically account for battery degradation by considering an increase in resistance and a decrease in capacity. For an algorithm considering a resistance increase, battery degradation is simplified as an increase in a single resistance component. Such algorithms may be implemented by automatically updating a look-up table (LUT) for such resistance. For an algorithm considering a capacity decrease, the total capacity is estimated by accumulating the discharge current over two state of charge (SOC) sections (e.g., from 95% to 5%) that span a sufficiently wide range to approximate a full discharge. However, these approaches may not adequately capture the complexity of battery degradation, which may involve more intricate behaviors than can be represented by simple resistance and capacity changes.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, an electronic device includes a battery; one or more processors; and a memory storing instructions, wherein the instructions, when executed by the one or more processors, cause the electronic device to: store an updated parameter value of at least one target parameter selected from among a plurality of degradation parameters based on monitoring of the battery; determine parameter values of the other parameters based on the updated parameter value of the at least one target parameter; estimate a battery state of the battery based on the updated parameter value of the at least one target parameter and the determined parameter values of the other parameters, using a battery state estimation model; update the parameter values of the other parameters based on the estimated battery state; and determine an updated battery state based on the updated parameter value of the at least one target parameter and the updated parameter values of the other parameters.

The instructions, when executed, may further cause the electronic device to obtain a measurement value for one or more of current, voltage, and temperature of the battery for each of partial operation times of the battery; identify a state of charge (SOC) section to which the battery belongs during each partial operation time; and determine a parameter value for a degradation parameter corresponding to the identified SOC section based on the measurement value.

The instructions, when executed, may further cause the electronic device to select the degradation parameter corresponding to the identified SOC section as the at least one target parameter in response to an accumulated time of the partial operation times in the identified SOC section exceeding a threshold time; and determine an updated parameter value of the selected target parameter based on parameter values determined during the partial operation times corresponding to the identified SOC section.

The instructions, when executed, may further cause the electronic device to select, as target parameters, a degradation parameter corresponding to the first SOC section and a degradation parameter corresponding to the second SOC section, in response to respective accumulated operation times in the first and second SOC sections each exceeding a threshold time.

The plurality of degradation parameters may include one or more of a capacity ratio of a cathode active material, anode solid electrolyte interphase (SEI) resistance, and electrode balancing.

The instructions, when executed, may further cause the electronic device to determine a parameter value of the reference parameter corresponding to the updated parameter value of the at least one target parameter, based on degradation trend information indicating a relationship between the at least one target parameter and the reference parameter; and update the determined parameter values of the other parameters based on the parameter value of the reference parameter.

The instructions, when executed, may further cause the electronic device to determine the parameter values of the other parameters corresponding to a parameter value of the reference parameter, based on degradation trend information indicating a relationship between the other parameters and the reference parameter.

The battery state estimation model may include one or both of an electrochemical model and a machine learning-based model.

The instructions, when executed, may further cause the electronic device to, based on degradation trend information indicating a relationship between the battery state and other parameters, update the parameter values of the other parameters to a value corresponding to the estimated battery state.

The instructions, when executed, may further cause the electronic device to determine the updated battery state for a target time point using estimation values of a battery state based on one or both of convergence of an error between the estimation values of the battery state and convergence of an error between updated values of the other parameters.

The electronic device may further include a display, wherein the instructions, when executed, further cause the electronic device to present, on the display, one or both of a state of health (SOH) corresponding to the updated battery state and a remaining charge amount determined based on the SOH.

The instructions, when executed, may further cause the electronic device to turn off the electronic device or reduce consuming power of the electronic device in response to a remaining charge amount determined based on the updated battery state being less than a threshold charge amount.

In one general aspect, a processor-implemented method includes storing an updated parameter value of at least one target parameter selected from among a plurality of degradation parameters based on monitoring of a battery; determining parameter values of the other parameters based on the updated parameter value of the at least one target parameter; estimating a battery state of the battery from the updated parameter value of the at least one target parameter and the determined parameter values of the other parameters using a battery state estimation model; updating the parameter values of the other parameters based on the estimated battery state; determining an updated battery state based on the updated parameter value of the at least one target parameter and the updated parameter values of the other parameters.

The storing of the updated parameter value of the at least one target parameter may include obtaining a measurement value for one or more of current, voltage, and temperature of the battery for each of partial operation times of the battery; identifying a state of charge (SOC) section corresponding to each partial operation time; and determining a parameter value for a degradation parameter corresponding to the identified SOC section based on the measurement value.

The storing of the updated parameter value of the at least one target parameter may further include selecting the degradation parameter corresponding to the identified SOC section as the at least one target parameter in response to an accumulated time of partial operation times in the identified SOC section exceeding a threshold time; and determining an updated parameter value of the selected target parameter based on parameter values determined during the partial operation times.

The storing of the updated parameter value of the at least one target parameter may further include selecting, as target parameters, degradation parameters corresponding to at least two SOC sections, in response to respective accumulated operation times in each SOC section exceeding a threshold time.

The determining of the parameter values of the other parameters may include determining a parameter value of the reference parameter corresponding to the updated parameter value of the at least one target parameter based on degradation trend information indicating a relationship between the at least one target parameter and the reference parameter; and updating the determined parameter values of the other parameters based on the parameter value of the reference parameter.

The determining of the parameter values of the other parameters may include updating the determined parameter values of the other parameters based on degradation trend information indicating a relationship between the other parameters and the reference parameter.

The updating of the parameter values of the other parameters may include, based on degradation trend information indicating a relationship between the battery state and the other parameters, updating the parameter values of the other parameters to a value corresponding to the estimated battery state.

In one general aspect, provided is a non-transitory computer-readable storage medium storing instructions that, when executed by one or more processors, cause the processor to perform the method described herein.

Other features and aspects will be apparent from the following detailed description, the drawings, and the claims.

### BRIEF DESCRIPTION OF THE DRAWINGS

FIG. 1 illustrates an example battery state estimation system according to one or more embodiments.
FIG. 2 illustrates an example electrochemical model according to one or more embodiments.
FIG. 3 illustrates an example degradation of a battery state according to one or more embodiments.
FIGS. 4 through 6 illustrate respective example degradation parameters according to one or more embodiments.
FIG. 7 illustrates an example battery state estimation method according to one or more embodiments.
FIG. 8 illustrates an example of updating a parameter and a battery state for a battery state estimation according to one or more embodiments.
FIG. 9 illustrates an example of a plurality of state of charge (SOC) sections of a full region of an SOC and a corresponding degradation parameter corresponding to each SOC section according to one or more embodiments.
FIGS. 10A through 10D illustrate respective examples of selecting a degradation parameter to be updated based on battery operation patterns according to one or more embodiments.
FIGS. 11 and 12 illustrate respective examples of determining values of other degradation parameters from a target degradation parameter based on a degradation trend according to one or more embodiments.
FIG. 13 illustrates an example degradation trend according to one or more embodiments.
FIG. 14 illustrates an example iterative update of a degradation parameter and a battery state according to one or more embodiments.
FIG. 15 illustrates an example configuration of an electronic device according to one or more embodiments.
Throughout the drawings and the detailed description, unless otherwise described or provided, the same drawing reference numerals may be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

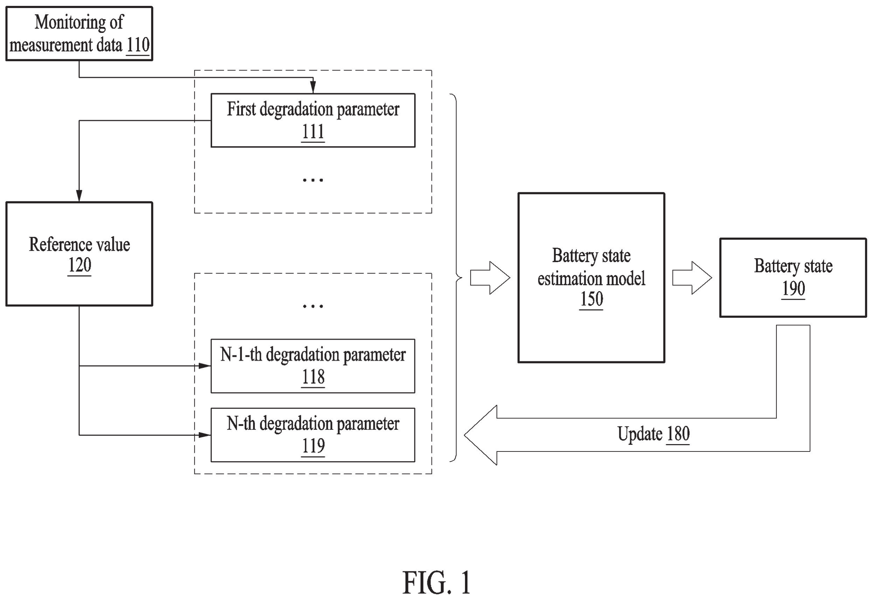

FIG. 1 illustrates an example battery state estimation system according to one or more embodiments.

The battery state estimation system may estimate a battery state 190, which is an indicator of one or more of electrical, chemical, and/or physical state of a battery. The battery state 190 may include, for example, a state of health (SOH), a state of charge (SOC), a state of power (SOP), a state of energy (SOE), and a state of function (SOF) of the battery. The SOH may be expressed as a ratio of a current capacity (e.g., a degraded capacity) to an initial capacity of the battery and may indicate the remaining useful life of the battery. Although SOH is primarily described as an example of the battery state 190 herein, examples are not limited thereto.

Battery performance may degrade over time with continued usage. Such degradation of the battery may be caused by a variety of factors, including a decrease in the amount of cathode or anode active materials, lithium plating, an increase in a simple resistance component, and an electrode balance shift. The degradation tendency and degradation level of the battery may vary depending on usage patterns and environment factors of the battery. As degradation progresses, the battery state 190 may change, for example, the SOH of the battery may decrease.

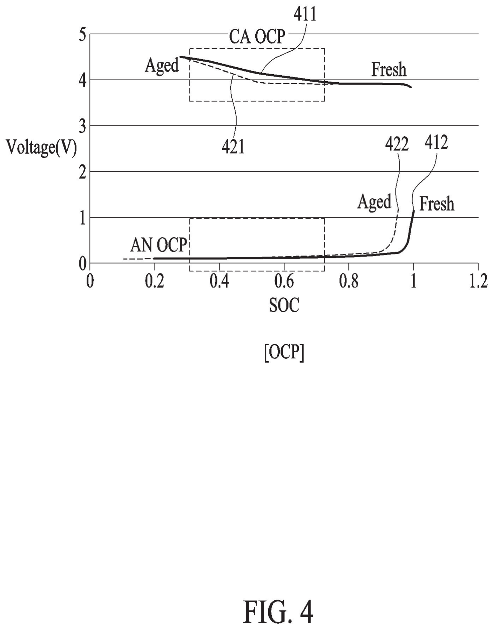

The battery state estimation system (e.g., an electronic device) may estimate battery state information (e.g., SOH) based on a plurality of battery degradation parameters. A degradation parameter is a parameter indicating a degradation state of the battery, a factor causing degradation of the battery, and/or a phenomenon, among parameters of an electrochemical model for the battery, and may include, for example, one or a combination of two or more of anode solid electrolyte interphase (SEI) resistance, a capacity of a cathode active material, and an electrode balance shift. The battery degradation parameter (hereinafter, referred to as a 'degradation parameter') is described in more detail below with reference to FIGS. 4 through 6.

An electronic device may perform monitoring of measurement data 110. The electronic device may collect pieces of measurement data such as voltage, current, and/or temperature of the battery through the monitoring of the measurement data. For example, the electronic device may collect the pieces of measurement data over partial operation time intervals. As described below, the electronic device may calculate and record degradation parameter values corresponding to each of the partial operation time intervals.

Based on the monitoring 110, the electronic device may determine a parameter value of at least one target parameter (e.g., a first degradation parameter 111) selected from among the plurality of degradation parameters. As described below, the electronic device may identify an SOC section to which an SOC value of the battery belongs at each partial operation time and may select, as the target parameter, the first degradation parameter 111 corresponding to a corresponding SOC section. For example, the electronic device may update the value of the first degradation parameter 111 using the values obtained during the partial operation time intervals for the first degradation parameter 111.

The electronic device may determine, among the plurality of degradation parameters, parameter values of other parameters based on an updated parameter value of the target parameter. The electronic device may determine a reference value 120 corresponding to the parameter value of the first degradation parameter 111 and then derive parameter values for the other parameters (e.g., an N-1-th degradation parameter 118 and an N-th degradation parameter 119, where N is an integer greater than or equal to 3) based on this reference value.

The electronic device may determine the reference value 120 (e.g., an SOH value) corresponding to the updated parameter value of the target parameter, based on degradation trend information (e.g., a trendline of a reference parameter value versus a target parameter value) representing the relationship between a reference parameter (e.g., SOH) and the target parameter. The trendline may be a straight line or a curve obtained by approximating data points (e.g., values of other parameters when any parameter has a predetermined value) indicating a relationship between two parameters. For example, the electronic device may determine the reference value 120 corresponding to an updated parameter value of the first degradation parameter 111. Although the reference value 120 is mainly described as an example of an SOH value herein, examples are not limited thereto.

The electronic device may determine the parameter value corresponding to the reference value 120 described above for other degradation parameters, based on the degradation trend information (e.g., a trendline of a reference parameter versus other parameters) between the reference parameter and the other parameters. For example, the electronic device may determine the N-1-th degradation parameter 118 and the N-th degradation parameter 119 based on the reference value 120 described above.

Using a battery state estimation model 150, the electronic device may estimate the battery state 190 based on the updated parameter value of the target parameter and the parameter values of the other parameters. The battery state estimation model 150 may include one or more of an electric circuit model, an electrochemical model, and a machine learning-based model.

The electrochemical model is a physical conservation equation and electrochemical reaction model and may serve to simulate physical characteristics associated with an electrochemical reaction occurring inside the battery. For example, the electrochemical model is obtained by modeling an internal physical phenomenon of the battery, such as lithium-ion concentration, potential of the battery, or the like, and the remaining battery power (e.g., the battery life or the battery state 190) may be estimated using the electrochemical model. The electrochemical model may be expressed as an electrochemical reaction occurring in an electrode/electrolyte interface, the concentration of an electrode/electrolyte, and a physical conservation equation associated with the conservation of charge. The electrochemical model may be modeled with various parameters including the plurality of degradation parameters. Parameters used in the electrochemical model may include geometric attributes (e.g., thickness, radius, or the like), open circuit potential (OCP), and material properties (e.g., electrical conductivity, ionic conductivity, and diffusion coefficient). To improve the estimation accuracy of the battery state 190 in a degradation state, in addition to an initial state of the battery, a degradation parameter in a degradation state must be accurately updated.

In the electrochemical model, various state variables, such as ion concentration, electrode potential, or the like, may be interdependent. The estimated voltage of the battery estimated from the electrochemical model may correspond to a potential difference between ends of a cathode and anode, and the lithium-ion concentration distribution of the cathode and anode may affect the potential of the cathode and anode. In addition, the average lithium-ion concentration of the cathode and anode may be used to estimate an SOC of the battery in the electrochemical model.

In addition to electrochemical models, the electronic device may also estimate the state information of the battery using the machine learning-based model. For example a trained neural network may be used to predict and output the state information of the battery based on degradation parameter inputs.

The electronic device may update 180 the parameter values of the other parameters based on the estimated battery state 190. For example, the electronic device may store updated parameter values of the other parameters based on the degradation trend information (e.g., a trendline) inferred from the estimated battery state 190.

The electronic device may determine an updated battery state 190 based on the updated parameter value of the target parameter and the updated parameter values of the other parameters. The electronic device may determine the updated battery state 190 for an estimation time point in response to convergence of the parameter value and the update of the battery state 190.

The electronic device of the battery state estimation system may be implemented using a fuel gauging (FG) integrated circuit (IC) chip for battery FG. The FG IC chip may be equipped with firmware that performs a state estimation operation of the battery described herein. The electronic device may be implemented as a portable electronic device or a home electronic appliance. However, an algorithm for estimating the state of the battery may be installed on the electronic device as software, in addition to the firmware described above. For example, the battery state estimation system may be implemented as a battery management system (BMS) including a function of estimating an SOH of the battery. In another example, the battery state estimation system may be implemented as a device (e.g., an electronic device) including a function of estimating the SOH of the battery. The battery state estimation system may also be integrated into battery-powered devices such as vehicles, electronic devices, or power storage units. By accurately estimating the SOH and remaining charge, the device can enhance user experience by reliably predicting remaining usage time and charging requirements, enabling continued stable operation within expected durations.

The battery state estimation system may update the remaining degradation parameters using those parameters already updated from measurement data collected in specific SOC sections. For example, the target parameter may be any one of anode SEI resistance, a capacity of a cathode active material, or an electrode balance shift. The remaining degradation parameters may be parameters other than the selected degradation parameters. Accordingly, the battery state estimation system may accurately predict the numerical values of the degradation parameters and the value of the battery state 190 (e.g., an SOH), even the battery operates only within a partial SOC section/range.

In contrast, in a first comparative example, a degradation state may be simplified due to a simple resistance increase and a capacity decrease. This approach may result in low accuracy, especially under discharge conditions or harsh operating environments (e.g., fast charging/discharging, low temperatures). In the first comparative example, a resting period (e.g., a low-current section) of about 1 hour under a full charge and discharge level condition may be required to accurately estimate the capacity decrease. Since a full discharge condition does not easily occur in actual use, it may be difficult to obtain the values of all degradation parameters of the electrochemical model. Consequently, this model may not provide all necessary degradation parameters and may lead to incomplete or inaccurate battery state estimation.

In a second comparative example, a primary internal degradation parameter may be estimated by analyzing the differences between an output value (e.g., voltage and SOC) of the electrochemical model and a measurement value (e.g., current, voltage, temperature) of the battery in a degradation state. However, in the second comparative example, under a partial discharge condition, an electrode balance shift value, which is one of the degradation parameters of the electrochemical model, may be limitedly estimated only when the discharge is performed to a region with a low SOC of 10%.

In a third comparative example, under a partial discharge condition, a degradation parameter may be estimated even in a section where an electrode balance shift value, which is one of the degradation parameters of the electrochemical model. In the third comparative example, some (e.g., the remaining two degradation parameters) of three degradation parameters may not be updated. As a result, the electrochemical model may remain incomplete and insufficient for full degradation estimation.

The proposed estimation embodiments described herein enable more accurate updates of both the target degradation parameter and other parameters, compared to approaches that simply map degradation information using look-up tables (LUTs). The following sections will describe one or more embodiments that automatically estimate and update battery degradation state variables by analyzing response characteristics (e.g., voltage response) of a degraded battery based on user-specific usage patterns.

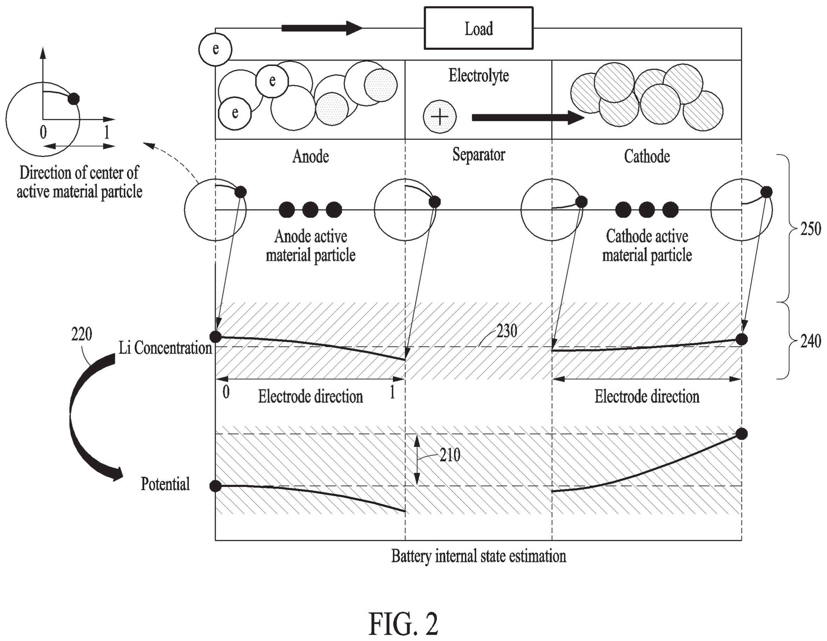

FIG. 2 illustrates an example electrochemical model according to one or more embodiments.

The electrochemical model may simulate an internal physical phenomenon of a battery, such as ion concentration, potential, or the related behavior of the battery. The electrochemical model may incorporate an electrochemical reaction occurring at an electrode/electrolyte interface, the concentration of an electrode/electrolyte, and a physical conservation equation associated with the conservation of charge. The electrochemical model may be defined using various model parameters, including geometric properties (e.g., a thickness and a radius of an electrode), OCP, and physical properties (e.g., electrical conductivity, ionic conductivity, and diffusion coefficient). The electrochemical model may include information (e.g., an equation) indicating relationships among various model parameters according to the internal physical phenomenon described above.

An electronic device may estimate the remaining battery power using various model parameters of the electrochemical model. In this context, in the electrochemical model, a plurality of parameters (e.g., state variables), including the concentration and potential, may be interdependent. The electronic device may estimate a potential difference between the anode and cathode, represented as an estimated voltage 210 of the battery, based on the parameters of the electrochemical model. The lithium-ion concentration distribution of the anode and cathode may have an influence 220 on the respective potentials of the anode and cathode. In addition, the electronic device may estimate the average lithium-ion concentration of the anode and cathode to determine an SOC of the battery according to the electrochemical model.

The lithium-ion concentration distribution may represent a lithium-ion concentration distribution within an electrode 240 or within an active material particle 250 located at a predetermined region in the electrode. The lithium-ion concentration distribution in the electrode 240 may represent a surface lithium-ion concentration distribution or an average lithium-ion concentration distribution of an active material particle along an electrode direction. The electrode direction may represent a direction connecting one end (e.g., a boundary adjacent to a collector) of the electrode to the opposite end (e.g., a boundary adjacent to a separator) of the electrode. In addition, the lithium-ion concentration distribution in the active material particle 250 may represent a lithium-ion concentration distribution in an active material particle in a direction of the center of the active material particle. The direction of the center of the active material particle may represent a direction connecting the center of the active material particle to the surface of the active material particle.

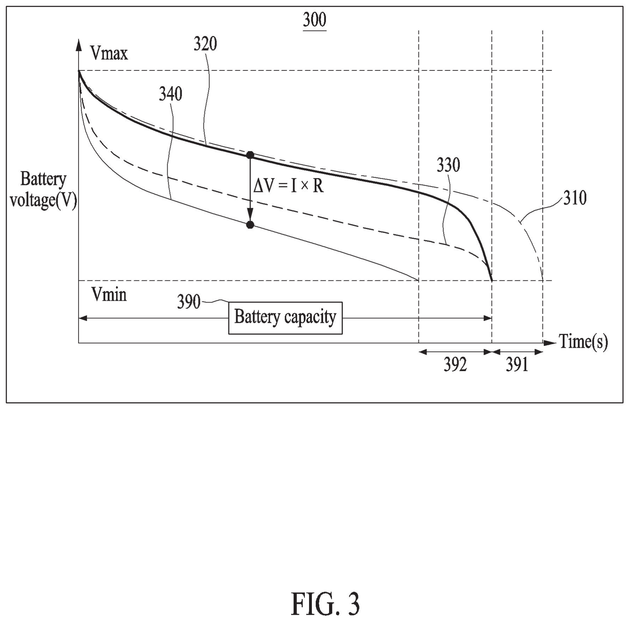

FIG. 3 illustrates an example graph depicting degradation of a battery state according to one or more embodiments.

FIG. 3 illustrates a degradation curve 300 of a battery state. The horizontal axis of the degradation curve 300 may represent a time period, such as, from a time point of full charge to a time point of full discharge. The graph includes curves representing voltage decreases for a fresh battery and a degraded battery over this time period from the time point of full charge.

For example, FIG. 3 illustrates open circuit voltage (OCV) 310 and cell voltage 330 of the fresh battery, and OCV 320 and cell voltage 340 of the degraded battery. As the battery degrades, a voltage decrease ΔV = I x R may occur due to a change in internal resistance R of the battery, which may be observed at various time points. Since OCV decreases due to the change in the internal resistance R, the time to reach the minimum voltage Vmin may be shortened. As a result, a battery capacity 390 may decrease. Degradation of the battery capacity 390 may be expressed as a difference 391 between the OCV 310 of the fresh battery and the OCV 320 of the degraded battery, or as a difference 392 between the cell voltage 330 reaching the minimum voltage of the fresh battery and the cell voltage 340 reaching the minimum voltage of the degraded battery.

FIGS. 4 through 6 illustrate respective example degradation parameters according to one or more embodiments.

Some of the various parameters of the electrochemical model described above may be degradation parameters that affect the degradation of a battery. The plurality degradation parameters may include one or more of a capacity ratio of a cathode active material, anode SEI resistance, and electrode balancing.

FIG. 4 illustrates a capacity ratio of a cathode active material as an example of a battery degradation parameter.

The capacity ratio of the cathode active material may be determined based on a ratio between a response characteristic (e.g., a voltage slope) in a degraded cell and a response characteristic (e.g., a voltage slope) in a fresh cell. FIG. 4 illustrates a voltage curve 411 of a cathode of the fresh battery, a voltage curve 421 of a cathode of the degraded battery, a voltage curve 412 of an anode of the fresh battery, and a voltage curve 422 of an anode of the degraded battery. As shown in FIG. 4, in an SOC section adjacent to the time point of full charge, a difference may occur between the voltage curves 411 and 421 of the cathodes of the fresh and degraded batteries, respectively.

For example, at start time point t1 and end time point t2, the ratio between the response characteristics may be determined to be a ratio between slope 1 determined from pieces of estimated voltage *V*1*_{Fresh}* and *V*2*_{Fresh}* and slope 2 determined from pieces of measured voltage *V*1*_{Aged}* and *V*2*_{Aged}.* When the current of the battery is reduced at a predetermined time point ta due to a change in the operation of an electronic device, the voltage of the battery may suddenly increase, but the ratio between the response characteristics may be determined only based on the ratio between the slope 1 determined from the pieces of estimated voltage *V*1*_{Fresh}* and *V*2*_{Fresh}* and the slope 2 determined from the pieces of measured voltage *V*1*_{Aged}* and *V*2*_{Aged},* at the start time point t1 and the end time point t2. The difference between the estimated voltage and measured voltage may gradually increase as time elapses (e.g., as the battery degrades), and the difference in characteristics may be expressed as the ratio between the slope 1 and the slope 2. The ratio between the response characteristics may be expressed as shown in Equation 1 below.${CA}_{ratio} = \frac{Estimated voltage difference}{Measured voltage difference} = \frac{V {1}_{Fresh} - V {2}_{Fresh}}{V {1}_{Aged} - V {2}_{Aged}}$

In Equation 1, as described above, a capacity ratio *CAᵣₐₜᵢₒ* of a cathode active material may be expressed as a ratio between a voltage difference (e.g., a voltage slope) at two time points of the degraded battery and a voltage difference (e.g., a voltage slope) at two time points of the fresh battery. The electronic device may update a degradation parameter corresponding to the capacity of the cathode active material by reflecting the determined capacity ratio *CAᵣₐₜᵢₒ* of the cathode active material in an electrochemical model.

The determined ratio between the response characteristics may not be reflected immediately in the degradation parameter but may instead be stored in a memory. When an update condition is reached, the degradation parameter of the electrochemical model may be updated based on stored values, such as average values and/or moving average values.

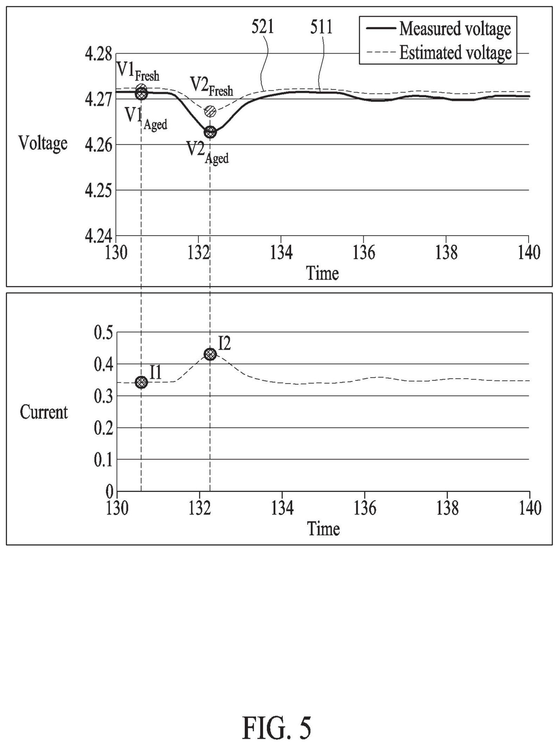

FIG. 5 illustrates the anode SEI resistance as an example of a degradation parameter.

FIG. 5 shows examples of estimated voltage 521 and measured voltage 511, both varying in response to a change in current of a battery. The voltage curve at the upper portion of the graph shown in FIG. 5 may represent a voltage change over a relatively short time interval. For example, when an electronic device equipped with a battery performs a task requiring large power or an electronic device exits a low-power (e.g., sleep) mode, the current of the battery may abruptly increase. As illustrated in FIG. 5, the current may be changed due to various causes. Due to the anode SEI resistance, the variation in voltage of a fresh battery and the variation in voltage of a degraded battery may differ in response to a sudden current change, as described above.

The anode SEI resistance may represent resistance occurring when SEI layers are stacked on the anode surface due to an anode side reaction. As the degradation progresses, the anode SEI resistance may gradually increase. The anode SEI resistance may be updated based on a difference in response characteristics between the estimated voltage 521 and the measured voltage 511. The electronic device may determine a resistance increase amount based on the variation in the estimated voltage 521, the variation in the measured voltage 511, and the variation in current, which may be expressed as shown in Equation 2 below.$\begin{matrix}{dV}_{Fresh} = V {1}_{{Fresh}_{}} - {V 2}_{{Fresh}_{}} \\ {dV}_{Aged} = V {1}_{Aged} - {V 2}_{Aged} \\ d \left(dV\right) = {dV}_{Aged} - {dV}_{Fresh} \\ = \left(V{1}_{Aged}-{V 2}_{Aged}\right) - \left(V{1}_{{Fresh}_{}}-{V 2}_{{Fresh}_{}}\right) \\ dI = 12 - I 1 \\ dΩ = \frac{d \left(dV\right)}{dI}\end{matrix}$

In Equation 2, dV*_{Fresh}* denotes the variation in the estimated voltage 521 estimated using an electrochemical model and may be calculated for two points where a current change is greater than a predetermined threshold value. Here, the electrochemical model may be an initial electrochemical model reflecting a fresh state of the battery without degradation or an electrochemical model reflecting a previous degradation state. dV*_{Aged}* denotes the variation in the measured voltage 511 of an actual battery. d/denotes the variation in current and may be determined to be *F* × Δ*jₙ*. Fdenotes a Faraday constant and Δ*jₙ* denotes the variation in current density. *d*Ω denotes a resistance increase amount, and using this, the variation in the anode SEI resistance may be determined as shown in Equation 3 below.$\begin{matrix}{dR}_{SEI} = d Ω \times {a}_{n} \times {l}_{n} \times area \\ {a}_{n} = \frac{3 \times {eps}_{a , s}}{{r}_{a}}\end{matrix}$

In Equation 3, *aₙ* denotes a specific surface area of an anode active material, *eps*_{*a*,*s*} denotes a volume fraction of the anode active material, and *rₐ* denotes a radius of the anode active material. *lₙ* denotes a thickness of an anode electrode and *area* denotes an area of the anode electrode. The electronic device may determine the variation in the anode SEI resistance to be the variation in degradation. Using the variation in the anode SEI resistance, the electronic device may update the degradation parameter corresponding to the anode SEI resistance.

The determined variation in the anode SEI resistance may not be reflected immediately in the degradation parameter but may instead be stored in a memory. When an update condition is reached, the degradation parameter of the electrochemical model may be updated based on stored values such as average values and/or moving average values.

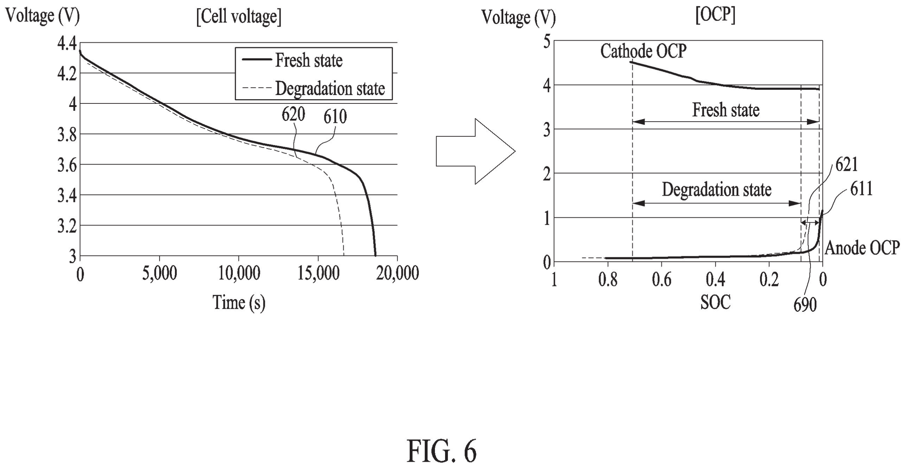

FIG. 6 illustrates electrode balancing (e.g., an electrode balance shift) as a degradation parameter.

FIG. 6 includes two graphs showing cell voltage, cathode OCP, and anode OCP for both a fresh state in which degradation does not occur and a degradation state in which degradation occurs. The cell voltage graph shows the discharge behavior during battery use. A voltage difference between a fresh state 610 and a degradation state 620 may be greater in a low SOC state (end stage of discharge) compared to a high SOC state (initial stage of discharge).

For example, in the low SOC state, a sudden change in voltage between the fresh state and degradation state may occur. Referring to the OCP graph, the cathode OCP may have a small difference between the fresh state 611 and the degradation state 621, whereas the anode OCP may have a large difference between the fresh state 611 and the degradation state 621 in the low SOC. In the degradation state 621, the anode OCP may be shifted to the left relative to the fresh state. This shift may be referred to as an electrode balance shift 690.

The electrode balance shift 690 may indicate the degree to which the balance between the anode and cathode is changed by a phenomenon in which lithium-ion is chemically coupled to the anode by a side reaction, preventing lithium from returning to the cathode. A more severe the degradation, a greater the electrode balance shift 690 may occur.

The SOC correction amount corresponding to the determined electrode balance shift may not be reflected immediately in the degradation parameter but may instead be stored in a memory. When an update condition is reached, the degradation parameter of an electrochemical model may be updated based on stored values (e.g., average values and moving average values).

While examples of degradation parameters have been described with reference to FIGS. 4 through 6, these examples are not limiting. Various other degradation parameters may be considered depending on the system design and application requirements.

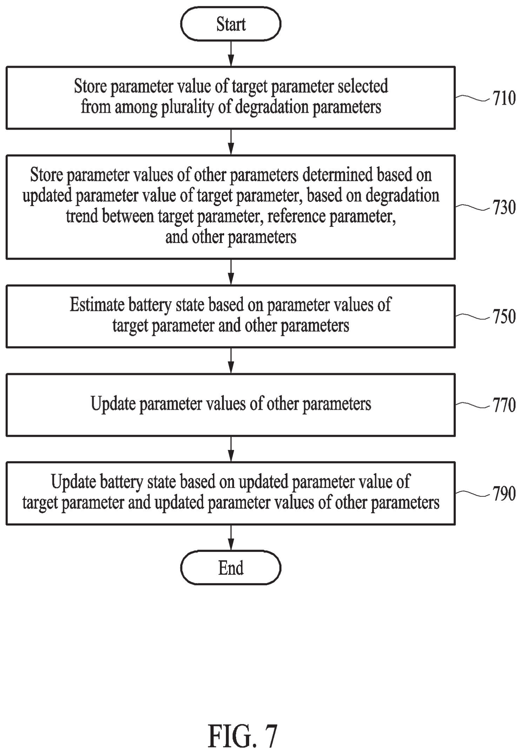

FIG. 7 illustrates an example battery state estimation method according to one or more embodiments.

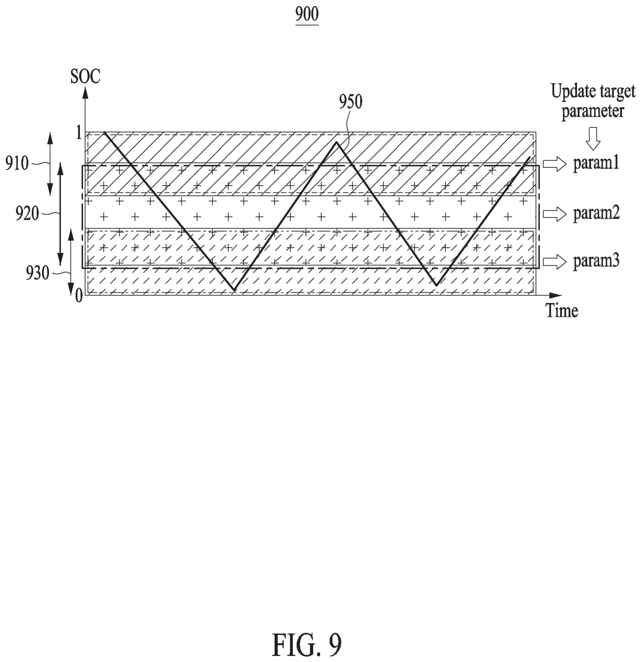

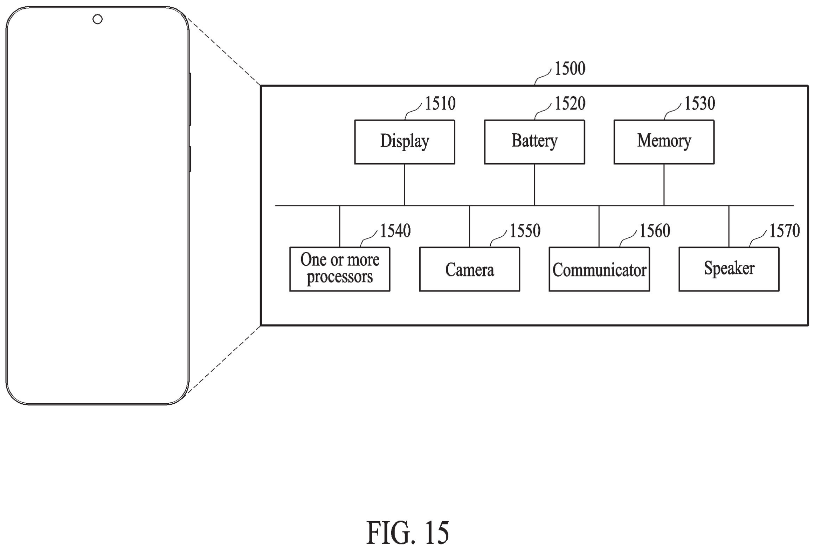

In operation 710, an electronic device may store a parameter value of a target parameter selected from among a plurality of degradation parameters. For example, based on monitoring of a battery, the electronic device may determine an updated parameter value for at least one target parameter selected from among the plurality of degradation parameters. The electronic device may store the updated parameter value in a memory (e.g., memory 1530 in FIG. 15). The selection of the target parameter is described in further detail with reference to FIG. 9.

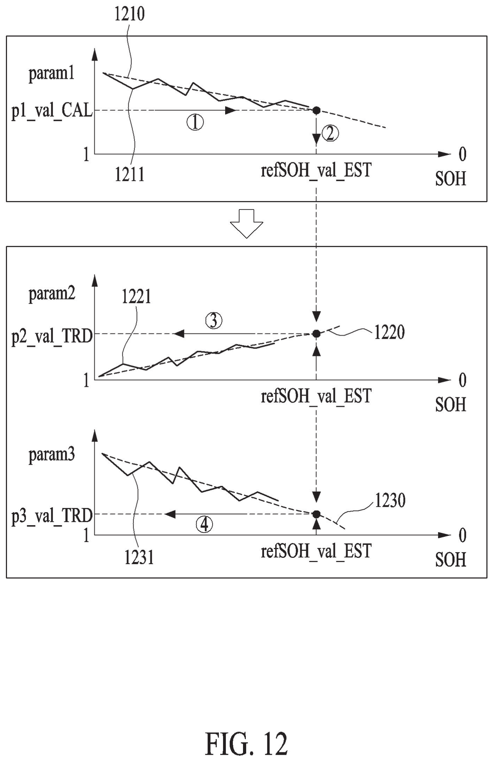

In operation 730, the electronic device may determine parameter values of other parameters based on the updated parameter value of the target parameter, and store the determined parameter values of the other parameters in the memory based on a degradation trend among the target parameter, a reference parameter, and the other parameters. For example, the electronic device may determine a reference value (e.g., a reference SOH value) corresponding to the updated parameter value in operation 730 and may determine the parameter values of the other parameters corresponding to the reference value. The determination of the reference value and the determination of the parameter values of the other parameter using the reference value are further described with reference to FIG. 12.

In operation 750, the electronic device may estimate a battery state based on the parameter values of the target parameter and the other parameters. For example, the electronic device may estimate a battery state (e.g., SOH) of the battery from the updated parameter value of the target parameter and the parameter values of the other parameters, using a battery state estimation model (e.g., an electrochemical model or a machine learning-based model). The electronic device may store the estimated battery state of the battery in the memory.

In operation 770, the electronic device may update the parameter values of the other parameters. For example, the electronic device may update the parameter values of the other parameters based on the estimated battery state, and may store the updated parameter values of the other parameters in the memory. The electronic device may determine a parameter value corresponding to the estimated battery state for the other parameters, based on a degradation trend (e.g., a trendline) between the battery state and the other parameters.

In operation 790, the electronic device may update the battery state based on the updated parameter value of the target parameter and the updated parameter values of the other parameters. For example, the electronic device may iteratively update the battery state and degradation parameter values until an error between the estimated battery state (e.g., an SOH value) in operation 750 and the updated battery state in operation 790 converges, thereby generating a final updated battery state. The electronic device may store the final updated battery state in the memory.

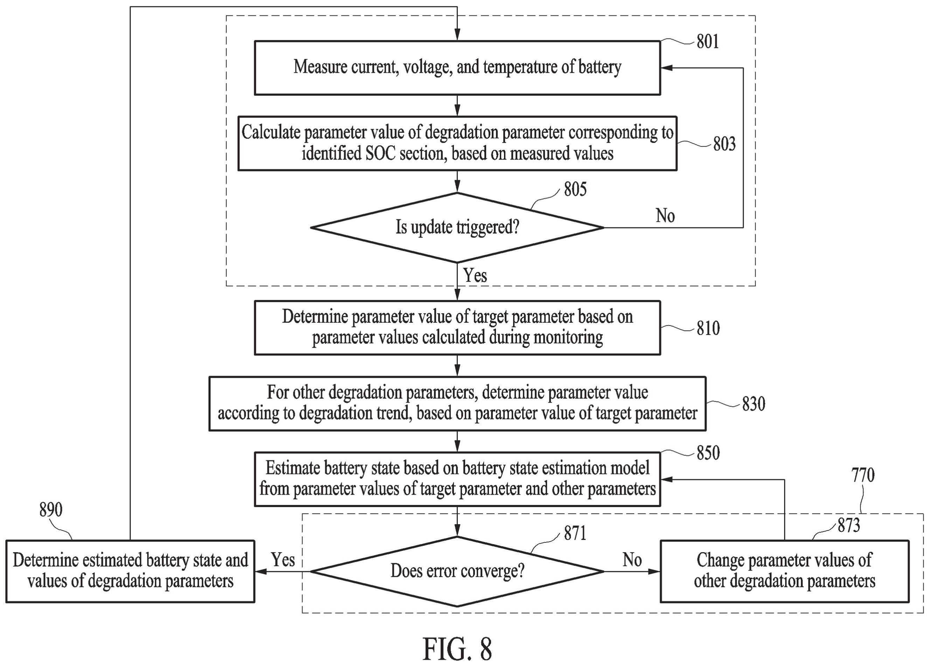

FIG. 8 illustrates an example of updating a parameter and a battery state for a battery state estimation according to one or more embodiments.

Under an operating condition where only a subset (e.g., one or more) of degradation parameters (e.g., a target parameter) among the degradation parameters of an electrochemical model may be updated, the electronic device may update other degradation parameters accordingly.

The electronic device may collect pieces of battery information through the monitoring of a battery. The pieces of battery information may include voltage, current, and temperature measurements at various time points. For example, in operation 801, the electronic device may measure the current, voltage, and temperature of the battery.

In operation 803, the electronic device may calculate a parameter value of a degradation parameter corresponding to an identified SOC section, based on measured values. For example, the electronic device may determine, among the degradation parameters of the battery, which degradation parameter exhibits a dominant change at a given time point based on the monitored battery information.

For example, the degradation parameter that exhibits a dominant change may vary depending on the SOC section. When the battery operates in a first SOC section, a parameter value of a first degradation parameter may change dominantly in a corresponding battery. When the first degradation parameter is a capacity ratio of a cathode active material, the electronic device may calculate the capacity ratio of the cathode active material as the parameter value of the degradation parameter, as described with reference to FIG. 4. Similarly, when the battery operates in a second SOC section, a parameter value of a second degradation parameter may change, and when the battery operates in a third SOC section, a parameter value of a third degradation parameter may change. The electronic device may calculate an anode SEI resistance value as described with reference to FIG. 5, when the second degradation parameter is the anode SEI resistance. The electronic device may calculate an electrode balance shift value as described with reference to FIG. 6, when the third degradation parameter is electrode balancing.

In operation 805, the electronic device may determine whether to update the degradation parameter. For example, the electronic device may determine whether pieces of information collected at the time point (e.g., estimation time point) when a battery state is to be estimated satisfy a predetermined update condition. The electronic device may determine that the update condition for the degradation parameter is satisfied when a time length in at least one SOC section exceeds a threshold time, in which calculated values for the degradation parameter exist in the at least one SOC section among a plurality of SOC sections. The electronic device may select the degradation parameter that satisfies the update condition as a target parameter.

In operation 810, the electronic device may determine a parameter value of the target parameter based on calculated parameter values during monitoring. For example, in operations 801, 803, and 805, the electronic device may update the parameter value of the target parameter to a statistical value (e.g., an average value, an intermediate value, a minimum value, or a maximum value) of the parameter values collected and calculated for the target parameter.

In operation 830, for other degradation parameters, the electronic device may determine the parameter value according to a degradation trend, based on the parameter value of the target parameter. For example, the electronic device may determine parameter values of the other degradation parameters based on a first degradation trend (e.g., a first trendline) between the target parameter and a reference parameter and a second degradation trend (e.g., a second trendline) between the reference parameter and the other parameters. The electronic device may determine a reference value (e.g., an SOH value) corresponding to the parameter value of the target parameter along the first trendline. The electronic device may determine the parameter values of the other parameters corresponding to the reference value (e.g., an SOH value) of the reference parameter along the second trendline.

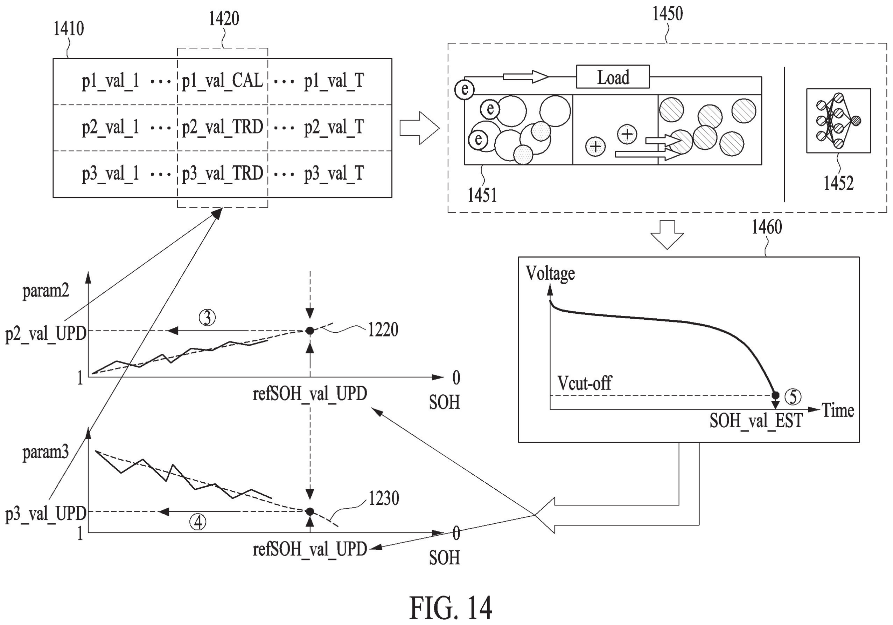

In operation 850, the electronic device may estimate a battery state based on the degradation parameter set, including the target parameter and the other parameters, using a battery state estimation model. For example, the electronic device may estimate a battery state value through simulation using the electrochemical model with the degradation parameter set as input. In another example, the electronic device may output the battery state by inference using a machine learning-based model, with a model parameter including the degradation parameter set. The inference of the battery state using the simulation according to the electrochemical model or machine learning-based model is described below with reference to FIG. 14.

For reference, when the reference parameter is an SOH in operation 830, the reference value (e.g., an SOH value) determined based on the parameter value of the target parameter and degradation trend may be different from the battery state (e.g., an SOH value) estimated in operation 850. For example, the degradation trend may be a trendline (e.g., a line obtained by approximating the trend between the reference parameter and the target parameter) between the target parameter and the reference parameter (e.g., an SOH), because the values of the remaining parameters are not considered in the trendline. The trendline may indicate an approximated relationship between two parameters, and the SOH value determined in operation 830 may be a value statistically (e.g., averagely) appearing in a predetermined parameter value of the target parameter. That is, even with the same SOH value, the parameter value of a predetermined degradation parameter may vary depending on a combination of the parameter values of the degradation parameter set. Accordingly, the determined parameter values of the other parameters in operation 830 may also be inaccurate because the parameter values are approximately determined based on the degradation trend without considering the values of the remaining parameters. As a result, an error may occur in the estimated battery state in operation 850.

In operation 871, the electronic device may determine whether an error converges. The error may be determined based on the estimated battery state and/or the values of the degradation parameters. For example, the electronic device may determine the error based on the difference between an estimated battery state obtained from an updated degradation parameter set in a first iteration and an estimated battery state obtained from an updated degradation parameter set in a second iteration, for the estimation time point. However, examples are not limited thereto, and the error may also be determined based on the difference between the updated parameter values in two iterations for each of the degradation parameters.

In operation 873, the electronic device may change the parameter values of the other degradation parameters when the error does not converge. The electronic device may iteratively update the battery state and the other degradation parameters using operations 873 and 850, until the error based on at least one of the battery state or degradation parameter converges. The error is an error between any iteration (e.g., an i-th iteration) and a previous iteration (e.g., an i-1-th iteration, where i is an integer greater than or equal to 2) and may be, for example, a value corresponding to a difference between the estimated battery states in the two iterations. In another example, the error may be an error between the updated parameters in adjacent iterations (e.g., an error between an updated degradation parameter value in the i-th iteration and an updated degradation parameter value in the i-1-th iteration). However, the error is not limited thereto, and the electronic device may also determine the error based on the updated battery states and the degradation parameter values in the iterations described above. The electronic device may terminate the update of the battery state and degradation parameter for the estimation time point (e.g., a current time point) when the error determined at the i-th iteration is in a convergence tolerance range.

In operation 890, the electronic device may determine the estimated battery state and the values of the degradation parameters when the error converges. For example, the electronic device may determine the finally updated battery state and degradation parameter values for the estimation time point (e.g., a current time point). The electronic device may present the remaining battery power or control the operation of the electronic device based on the determined battery state and degradation parameter values for the estimation time point.

FIG. 8 illustrates an example of updating the parameter values of the other degradation parameters while maintaining the parameter value of the target parameter. However, examples are not limited thereto. When the error does not converge within a set number of iterations or the error remains above the convergence tolerance threshold, the electronic device may re-update the parameter value of the target parameter in addition to the other degradation parameters. In such cases, the electronic device may re-estimate the battery state using newly updated target parameter values and other parameter values, based on the battery state estimation model (e.g., an electrochemical model or machine learning-based model).

FIG. 9 illustrates an example of a plurality of SOC sections within a full region of an SOC and a corresponding degradation parameter corresponding to each SOC section according to one or more embodiments.

An SOC 900 of a battery may vary based on battery operations such as charging and/or discharging. Depending on the usage scenario of an electronic device, a section in which an SOC value 950 remains may vary in the electronic device. Depending on the section in which the SOC value 950 remains, the variation in a degradation parameter according to an electrochemical model may vary.

The SOC regions of the battery may be divided into multiple SOC sections (also referred to as charge zones). While the battery operates in a predetermined range of SOC sections, a value of a portion of a plurality of degradation parameters may change. For example, in a predetermined SOC section, the variation in a portion (e.g., a target parameter) among the plurality of degradation parameters may be greater than the variation in other parameters. The target parameter may exhibit a dominant variation in a corresponding SOC section compared to the variation in the other parameters. There may be an SOC section where a change occurs for each of the plurality of degradation parameters. Accordingly, the SOC region of the battery may include the SOC section corresponding to each of the degradation parameters.

At least one of the SOC sections may partially overlap other SOC sections. For example, a first SOC section 910 may range from an SOC of 70% to an SOC of 100% and a second SOC section 920 may range from an SOC of 30% to an SOC of 80%, therefore the two SOC sections may have an overlapped zone from an SOC of 70% to an SOC of 80%. In addition, at least one of the SOC sections may not overlap other SOC sections. For example, a third SOC section 930 may range from an SOC of 0% to an SOC of 40%, and it may not overlap with the first SOC section 910. Among the SOC sections, the first SOC section 910 may partially overlap the second SOC section 920 and may not overlap the third SOC section 930. FIG. 9 illustrates an example in which a first degradation parameter param1 is mapped to the first SOC section 910, a second degradation parameter param2 is mapped to the second SOC section 920, and a third degradation parameter param3 is mapped to the third SOC section 930.

The electronic device may identify a target parameter that satisfies an update condition among the degradation parameters of an electrochemical model. The update condition may be determined based on one or a combination of two or more of: the number of cycles in which the battery operates in a partial SOC section corresponding to a predetermined parameter, an accumulated use capacity, an accumulated use time, and the number of degradation variations stored in a memory. For example, to update the degradation parameter using degradation variations accumulated as the battery is charged and discharged several times, one or a combination of two or more of the number of cycles, the accumulated use capacity, the accumulated use time, and the number of degradation variations of the battery stored in the memory may be used as the update condition. The update condition may be set independently for each of the anode SEI resistance, the capacity of the cathode active material, and the electrode balance shift such that a predetermined degradation parameter may be more frequently updated than the other degradation parameters. However, examples of the update condition are not limited thereto.

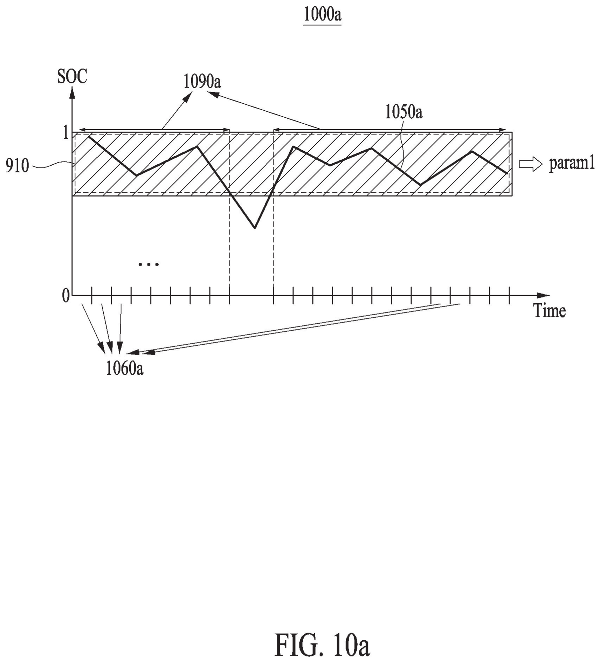

FIGS. 10A through 10D illustrate examples of selecting a degradation parameter to be updated based on battery operation patterns according to one or more embodiments.

FIG. 10A illustrates an example 1000a in which a battery operates for a duration exceeding a threshold time in the first SOC section 910.

An electronic device may obtain one or more measurement values of battery current, voltage, and temperature for each of partial operation times of the battery. The electronic device may collect values measured for each of the partial operation times and store the collected values in a memory. The electronic device may identify an SOC section applicable to the battery at each partial operation time. In FIG. 10A, the battery operates during most of the operation time in the first SOC section 910.

Based on the measurement values of a degradation parameter corresponding to the identified SOC section, the electronic device may determine a parameter value at a corresponding partial operation time. For example, in FIG. 10A, when k partial operation times 1060a are identified as belonging to the first SOC section 910, the electronic device may individually determine k parameter values for the first degradation parameter param1, using the measurement values collected from the k partial operation times 1060a. As described above with reference to FIGS. 4 through 6, the electronic device may determine the value of the degradation parameter. The calculated k parameter values may be stored in the memory, where k is an integer equal to or greater than 1.

In addition, for a partial operation time belonging to an SOC section other than the first SOC section 910, the electronic device may determine and store parameter values of degradation parameters corresponding to other SOC sections. Furthermore, the partial operation time is the first SOC section 910 and may belong to different SOC sections in an overlapping manner. In such cases, the electronic device may determine and store the parameter values of the degradation parameters respectively corresponding to the respective SOC sections to which the battery belongs at the partial operation time.

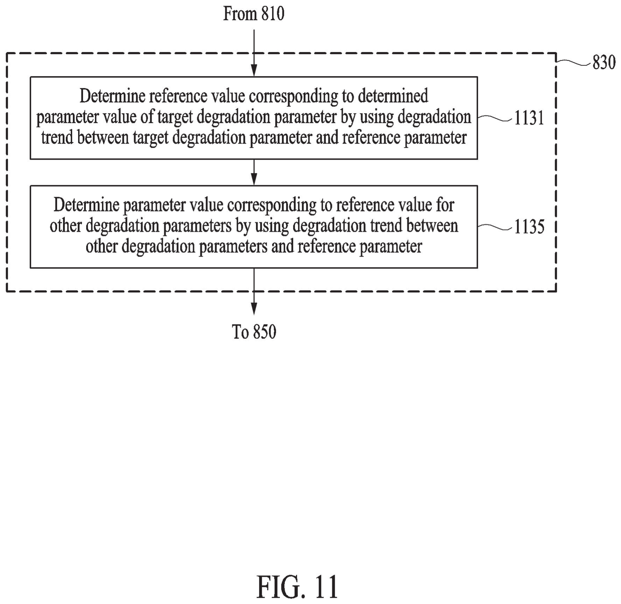

For reference, the determination of the parameter values based on the measurement values obtained for each of the partial operation times may be performed by a power management integrated circuit (PMIC) of the electronic device. However, examples are not limited thereto, and the determination may be performed by another processing circuitry (e.g., a processor) of the electronic device. Here, the determined parameter values may be used to define data points (e.g., points corresponding to the parameter values and the reference parameter values) to be described below with reference to FIGS. 11 through 13.

The electronic device may select the degradation parameter corresponding to the identified SOC section as a target parameter when an accumulated time 1090a of the k partial operation times 1060a corresponding to the identified SOC section exceeds a threshold time. The partial operation time may be, for example, a partial charge cycle and/or a partial discharge cycle. The accumulated time 1090a of the k partial operation times 1060a may represent the total of the time lengths across the k partial operation times 1060a. As described above, when an SOC value 1050a of the battery remains in the first SOC section 910 beyond the threshold time, the variation in the first degradation parameter param1 may be dominant. In such cases, the parameter value of the first degradation parameter param1 may be an update target.

The electronic device may determine an updated parameter value of the selected target parameter based on the determined parameter values at the k partial operation times 1060a corresponding to the identified SOC section. For example, the electronic device may determine, to be the updated parameter value of the target parameter, a statistical value (e.g., an average value) of the determined parameter values (e.g., k parameter values) based on the measurement values of the k partial operation times 1060a that are identified as the first SOC section 910, before the SOC value 1050a remains in the first SOC section 910 beyond the threshold time.

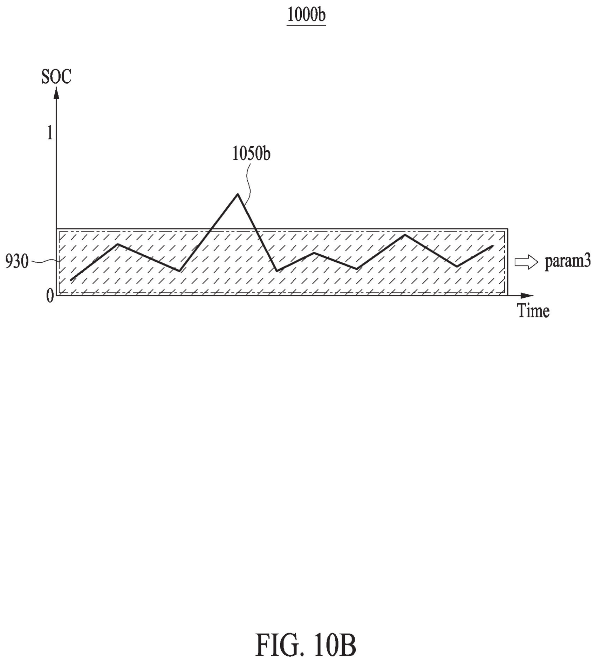

Although the first degradation parameter param1 is primarily described with reference to FIG. 10A, examples are not limited thereto. Similarly, when the SOC value 1050a of the battery remains in the second SOC section 920 beyond the threshold time, the influence on the second degradation parameter param2 may be dominant. In such cases, the parameter value of the second degradation parameter param2 may be an update target. The description provided with reference to FIG. 10A may similarly apply to FIGS. 10B through 10D.

FIG. 10B illustrates an example 1000b in which the battery operates beyond the threshold time in the third SOC section 930.

As illustrated in FIG. 10B, when an SOC value 1050b of the battery remains in the third SOC section 930 beyond the threshold time, the variation in the third degradation parameter param3 may be significant. In such cases, the parameter value of the third degradation parameter param3 may be an update target. The threshold time may be, but is not limited thereto, a predetermined time length and may be a time length corresponding to a threshold ratio in a predetermined reference time length. The threshold time may be set to be the same for each of the degradation parameters but is not limited thereto, and different threshold times may be set.

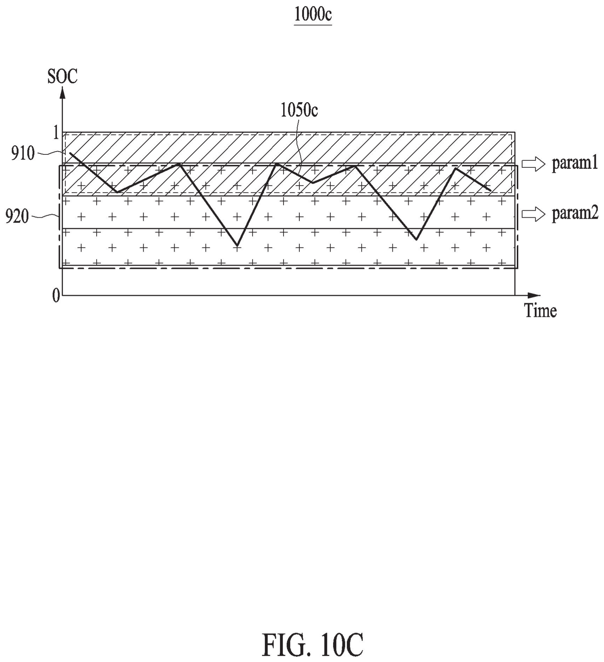

FIG. 10C illustrates an example 1000c in which the battery operates beyond the threshold time in the first SOC section 910 and the second SOC section 920.

An SOC value 1050c of the battery may exceed the threshold time in two or more SOC sections (e.g., the first SOC section 910 and the second SOC section 920). The electronic device may select, as target parameters, a degradation parameter corresponding to the first SOC section 910 (e.g., the first degradation parameter param1) and a degradation parameter corresponding to the second SOC section 920 (e.g., the second degradation parameter param2) when, among the SOC sections, a first accumulated operation time corresponding to the first SOC section 910 and a second accumulated operation time corresponding to the second SOC section 920 respectively exceed the threshold time.

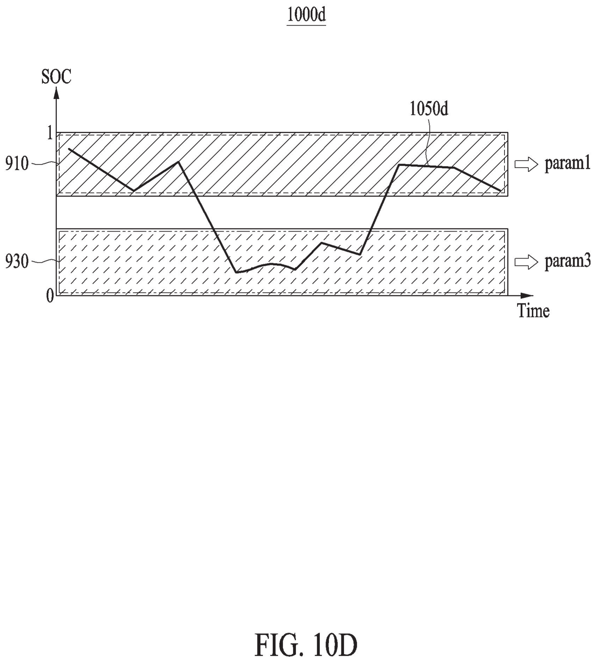

FIG. 10D illustrates an example 1000d in which the battery operates beyond the threshold time in the first SOC section 910 and the third SOC section 930.

An SOC value 1050d of the battery may exceed the threshold time in the first SOC section 910 and the third SOC section 930. The electronic device may select, as target parameters, the degradation parameter corresponding to the first SOC section 910 (e.g., the first degradation parameter param1) and a degradation parameter corresponding to the third SOC section 930 (e.g., the third degradation parameter param3) when, among the SOC sections, the first accumulated operation time corresponding to the first SOC section 910 and a third accumulated operation time corresponding to the third SOC section 930 respectively exceed the threshold time.

Examples in which the accumulated operation time for each of the degradation parameters exceeds the threshold time are not limited to the description provided with reference to FIGS. 10A through 10D, and there may be more than three degradation parameters that satisfy an update condition (e.g., when the accumulated operation time exceeds the threshold time) at a predetermined time point. Whether the update condition is satisfied for each of the degradation parameters may be independently determined. Once the accumulated operation time in the partial SOC section corresponding to each of the degradation parameters exceeds the threshold time, the determined value for a corresponding parameter may be obtained and stored, the accumulated operation time may be initialized and the measurement value of the corresponding partial SOC section may be monitored again.

FIGS. 11 and 12 illustrate examples of determining values of other degradation parameters from a target degradation parameter based on a degradation trend according to one or more embodiments.

In operation 1131, an electronic device may determine a reference value (e.g., a parameter value of a reference parameter such as an SOH value) corresponding to a determined parameter value of a target degradation parameter using a degradation trend (e.g., first degradation trend information) between the target degradation parameter and the reference parameter. The first degradation trend information is information indicating a relationship between the target parameter and the reference parameter and may include a trendline obtained by approximating a trend between the target parameter and the reference parameter.

FIG. 12 illustrates an example in which the first degradation parameter param1 is selected as the target parameter. The electronic device may determine a target parameter value p1_val_CAL (e.g., a parameter value of a target degradation parameter) by performing the operations described above with reference to FIGS. 9 through 10D. The electronic device may determine a reference parameter value refSOH_val_EST corresponding to the first degradation parameter value p1_val_CAL in a trendline 1210 between the first degradation parameter and an SOH parameter. The trendline 1210 may be a line obtained by approximating data points 1211 (or a graph corresponding to data points) corresponding to the values of the first degradation parameter and the values of the reference parameter. Each data point may be expressed as a determined and/or updated parameter value based on measurement values collected while monitoring battery information. Each data point may be a point in which one axis (e.g., a vertical axis) is mapped to a determined parameter value and the other axis (e.g., a horizontal axis) is mapped to a battery state (e.g., an SOH value) determined according to the operations of FIG. 14 to be described below. FIG. 12 illustrates a process of determining the reference parameter value refSOH_val_EST from the first degradation parameter value p1_val_CAL using arrows ① and ②. For reference, for intuitive understanding, in FIG. 12, an SOH of the horizontal axis is described as decreasing from 1 to 0. This may be because the SOH may degrade or decrease over time.

In operation 1135, the electronic device may determine a parameter value corresponding to a reference value for other degradation parameters by using a degradation trend (e.g., second degradation trend information) between the other degradation parameters and the reference parameter. For example, the electronic device may determine the parameter values of the other parameters based on the parameter value of the reference parameter. The second degradation trend information may indicate a relationship between the other parameters and the reference parameter.

For example, the electronic device may also determine parameter values of the remaining degradation parameters, for example, the second degradation parameter param2 and the third degradation parameter param3, based on corresponding degradation trends. The electronic device may determine a second degradation parameter value p2_val_TRD corresponding to the reference parameter value refSOH_val_EST in a trendline 1220 between the second degradation parameter and the reference parameter. The trendline 1220 may be a line obtained by approximating data points 1221 corresponding to the values of the second degradation parameter param2 and the values of the reference parameter. FIG. 12 illustrates a process of determining the second degradation parameter value p2_val_TRD from the reference parameter value refSOH_val_EST using arrow ③. Similarly, the electronic device may determine a third degradation parameter value p3_val_TRD corresponding to the reference parameter value refSOH_val_EST in a trendline 1230 between the third degradation parameter and the reference parameter. The trendline 1230 may be a line obtained by approximating data points 1231 corresponding to the values of the third degradation parameter and the values of the reference parameter. FIG. 12 illustrates a process of determining the third degradation parameter value p3_val_TRD from the reference parameter value refSOH_val_EST using arrow ④.

As the degradation trend is approximated information, the first degradation parameter value p1_val_CAL, the second degradation parameter value p2_val_TRD, and the third degradation parameter value p3_val_TRD obtained from FIG. 12 may be preliminary parameter sets. The preliminary parameter sets may be used to estimate a preliminary battery state, as illustrated in FIG. 14, which may be corrected through iterative updates.

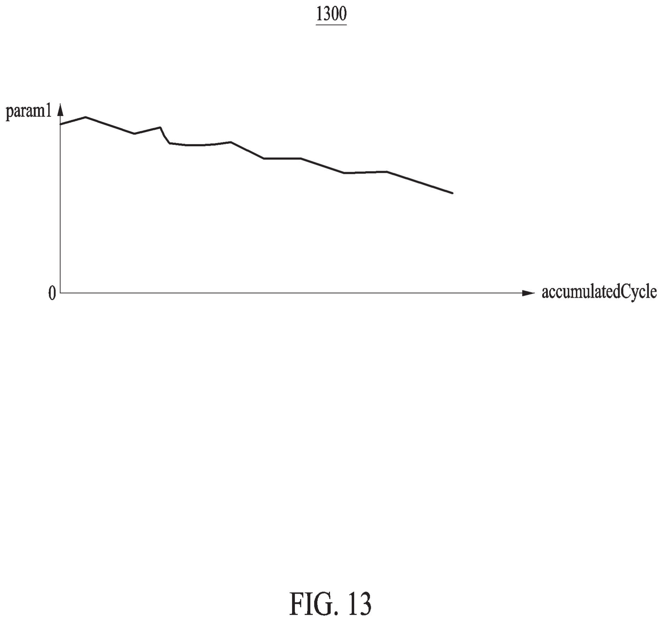

FIG. 13 illustrates an example degradation trend according to one or more embodiments.

In FIG. 12, an example in which the degradation trend information is the reference parameter and indicates the trend of each of the degradation parameters versus the SOH is mainly described. However, examples are not limited thereto. In FIG. 13, as a reference parameter, degradation trend information 1300 indicating a trend of each degradation parameter (e.g., a first degradation parameter) versus an accumulated cycle (e.g., a horizontal axis) may also be used to determine values of other parameters.

FIG. 14 illustrates an example of an iterative update of a degradation parameter and a battery state according to one or more embodiments.

An electronic device may estimate battery states 1460 from parameters 1410 using a battery state estimation model 1450 that includes an electrochemical model 1451. The electronic device may estimate the battery states 1460 from the parameters 1410 including an updated parameter set 1420 at an estimation time point. The updated parameter set 1420 at the estimation time point may include the updated first degradation parameter value p1_val_CAL, the updated second degradation parameter value p2_val_TRD, and the updated third degradation parameter value p3_val_TRD. As described above, the first degradation parameter value p1_val_CAL may be a value determined and updated based on at least a portion of the measurement values collected up to the estimation time point, and the second degradation parameter value p2_val_TRD and the third degradation parameter value p3_val_TRD may be values determined according to a degradation trend based on the first degradation parameter value p1_val_CAL. For example, the battery state estimation model 1450 may include one or both of the electrochemical model 1451 and a machine learning-based model 1452.

For reference, in FIG. 14, the parameter set 1420 may represent different states over the battery's lifecycle. For example, p1_val_1, p2_val_1, and p3_val_1 may represent degradation parameter values of a fresh battery, while p1_val_CAL, p2_val_TRD, and p3_val_TRD may represent degradation parameter values at the estimation time point, and p1_val_T, p2_val_T, and p3_val_T may represent degradation parameter values at a predetermined time point (e.g., the final degradation time point at which the battery becomes unavailable).

When the battery state estimation model 1450 is the electrochemical model 1451, the electronic device may perform simulation according to the electrochemical model 1451. For example, the electronic device may determine voltage (e.g., OCV or cell voltage) corresponding to the parameters 1410 (e.g., parameter sets) for each time point according to the electrochemical model 1451. The time point may be defined as a time that elapses from a fully charged state of the battery to a fully discharged state of the battery. The electronic device may determine the battery states 1460 for each time point until the determined voltage reaches cutoff voltage (e.g., Vcut-off) based on the model parameters 1410 including the degradation parameter set 1420. The time point at which the determined voltage reaches the cutoff voltage may be converted into the battery states 1460 (e.g., an estimated SOH value SOH_val_EST).

When the battery state estimation model 1450 is the machine learning-based model 1452, the electronic device may perform inference on the battery states 1460 using the machine learning-based model 1452. For example, the electronic device may determine the battery states 1460 by applying, to the machine learning-based model 1452, various model parameters 1410 including the degradation parameter set 1420. The machine learning-based model 1452 is a model designed and trained to output the battery states 1460 (e.g., SOH values) from the parameter values defined using the electrochemical model 1451 and may include, for example, a neural network. The electronic device may estimate the battery states 1460 (e.g., the estimated SOH value SOH_val_EST) using the machine learning-based model 1452.

The electronic device may update a reference value based on the estimated SOH value SOH_val_EST. In FIG. 14, the reference parameter is an SOH parameter, and an updated reference parameter value refSOH_val_UPD is illustrated. The updated reference parameter value refSOH_val_UPD may be equal to, but is not limited thereto, the estimated SOH value SOH_val_EST. A value (e.g., a value obtained by multiplying a weight by the estimated SOH value SOH_val_EST) obtained by correcting the estimated SOH value SOH_val_EST may also be used as the updated reference parameter value refSOH_val_UPD.

The electronic device may update parameter values of other parameters to values corresponding to estimated values of the battery states 1460 based on degradation trend information indicating a relationship between the battery states 1460 and the other parameters. For example, the electronic device may determine an updated second parameter value p2_val_UPD corresponding to the reference parameter value refSOH_val_UPD in the trendline 1220 indicating a relationship between the SOH parameter and the second degradation parameter param2. Similarly, the electronic device may determine an updated third parameter value p3_val_UPD corresponding to the reference parameter value refSOH_val_UPD in the trendline 1230 indicating a relationship between the SOH parameter and the third degradation parameter param3. The electronic device may obtain the updated degradation parameter set 1420 by replacing the values of the second degradation parameter param2 and the third degradation parameter param3 of the degradation parameter set 1420 corresponding to the estimation time point in the parameters 1410 with the second parameter value p2_val_UPD and the third parameter value p3_val_UPD, respectively. The updated degradation parameter set 1420 may be used for a new estimation of the battery states 1460.

The electronic device may determine the battery states 1460 that are updated for a target time point by using the estimated values of the battery states 1460 based on at least one of convergence of an error between the estimated values (e.g., SOH_val_EST and SOH_val_EST') of the battery states 1460 or convergence of an error between updated values of the other parameters. For example, the electronic device may determine whether an error converges. The electronic device may update the battery states 1460 and the parameters 1410 through a plurality of iterations. The electronic device may determine whether a difference between the updated battery states 1460 (e.g., SOH values) and/or a difference between the parameters 1410 (e.g., degradation parameter values) in a plurality of iterations (e.g., as adjacent iterations, an i-th iteration and an i-1-th iteration) are in a convergence tolerance range.

For example, in FIG. 14, the electronic device may estimate a first SOH value SOH_val_EST based on the degradation parameter set 1420 (p1_val_CAL, p2_val_TRD, and p3_val_TRD) in a first iteration. The electronic device may estimate a second SOH value SOH_val_EST' based on the degradation parameter set 1420 of (p1_val_CAL, p2_val_UPD, and p3_val_UPD) in a second iteration. The electronic device may calculate an error based on a difference between the first SOH value SOH_val_EST and the second SOH value SOH_val_EST'. The electronic device may calculate an error based on a difference between the degradation parameter set 1420 of (p1_val_CAL, p2_val_TRD, and p3_val_TRD) and the degradation parameter set 1420 of (p1_val_CAL, p2_val_UPD, and p3_val_UPD). The error between the parameter sets may be calculated based on, but is not limited thereto, a difference between corresponding parameter values (e.g., p2_val_TRD and p2_val_UPD). The electronic device may also determine whether an error converges by calculating the entire error from the error based on the difference between the battery states 1460 in the iterations and the error based on the difference between the parameter sets.

The electronic device may determine the final degradation parameter set 1420 and the final battery states 1460 (e.g., the determined SOH value for the estimation time point) by iterating the update of the parameter set 1420 and the estimation of the battery states 1460 until a convergence condition (e.g., the degradation parameters and the battery states 1460) is satisfied. The convergence condition (or termination condition) may be a condition in which the variation in the degradation parameter value and/or battery state value by the iterative update described above is in the convergence tolerance. The electronic device may finally determine the updated battery states 1460 (e.g., SOH values) for the estimated time point (e.g., current time point) when the error converges.

FIG. 15 illustrates an example configuration of an electronic device according to one or more embodiments.

An electronic device 1500 may include a display 1510, a battery 1520, a memory 1530, one or more processors 1540, a camera 1550, a communicator 1560, and a speaker 1570. The electronic device 1500 may be implemented as a mobile terminal, a vehicle, an aerial vehicle, a head-mounted display (HMD) device, and a wearable device, and may also be implemented as various devices equipped with the battery 1520.

The electronic device 1500 may use the battery 1520 as a power source. For example, the battery 1520 may have a single cell reference capacity of 10 ampere hours (Ah) or less and may be a pouch-type cell but is not limited to thereto. The electronic device 1500 may be a portable terminal, for example, a smartphone. The display 1510 provided in the electronic device 1500 may display information about the battery 1520 and/or an operation screen of the electronic device 1500. In FIG. 15, for ease of description, the electronic device 1500 is described as a smartphone, but various terminals, such as a laptop, a tablet personal computer (PC), and a wearable device, may be applied without limitations.

The display 1510 may display data processed by the one or more processors 1540 or the operation of the electronic device 1500. Further, the display 1510 may be a touchscreen display for detecting a touch gesture that is input from a user. The touch gesture detected on the touchscreen display may be transmitted to the one or more processors 1540 and processed.

The battery 1520 may supply power for the operation of the electronic device 1500. For example, the battery 1520 may supply power to the display 1510, the memory 1530, the one or more processors 1540, the camera 1550, a cover, the communicator 1560, and the speaker 1570. The battery 1520 may have a capacity per unit cell of 10 Ah or less. The electronic device 1500 may include a PMIC for power management of the battery 1520 (e.g., a battery cell and/or a battery pack).

The memory 1530 may store at least one of a battery state estimation model, parameters (e.g., a connection weight of a neural network and a coefficient of an electrochemical model) according to an electrochemical model, parameter values of degradation parameters, measurement values monitored for the battery 1520, or estimated battery states (e.g., SOH values). The memory 1530 may store at least one of a parameter value calculated for a partial operation time for each degradation parameter (see FIGS. 4 to 6), an updated parameter value for a selected target parameter (see FIGS. 10A to 10D), a reference parameter value, parameter values of other parameters determined according to a degradation trend (see FIGS. 11 to 13), or updated parameter values of the other parameters (see FIG. 14). The electronic device 1500 may store the above-described parameter values separately in one or more memories 1530 but is not limited thereto, and for memory efficiency, may store only parameter values determined through the iterative operations of FIG. 14 for the same estimation time point. The memory 1530 may store the state values (e.g., SOH values) and various parameter values described herein.

In addition, the memory 1530 may include a volatile memory and a non-volatile memory. The memory 1530 may store an electrochemical model and/or a machine learning-based model as a state estimation model of the battery 1520.

The one or more processors 1540 may estimate voltage of the battery 1520 using the electrochemical model. Additionally, the one or more processors 1540 may control the overall operation of the electronic device 1500. For example, the one or more processors 1540 may present the estimated voltage of the battery 1520 on the display 1510. The one or more processors 1540 may each be a microcontroller unit (MCU).

The electronic device 1500 may further include a PMIC. The memory 1530 and the one or more processors 1540 may be included in the PMIC, and the electronic device 1500 may have a separate application processor. In this case, the one or more processors 1540 of the PMIC may provide the estimated state of the battery 1520 (e.g., an SOH value and/or an SOC value) to the application processor as described above. The application processor may also output the result (e.g., the remaining battery power and/or expected remaining operation time) obtained by processing data regarding the state of the battery 1520 received from the PMIC through the display 1510. However, examples are not limited thereto, and in another example, the memory 1530 and the one or more processors 1540 may not be included in the PMIC. In this case, the one or more processors 1540 of the electronic device 1500 may perform state estimation of the battery 1520 and presentation of information derived from the state of the battery 1520.

The one or more processors 1540 may estimate state information of the battery 1520 using the state estimation model (e.g., an electrochemical model or a machine learning-based model) of the battery 1520 corresponding to the battery 1520. The electronic device 1500 may collect pieces of measurement values of voltage, current, and temperature by monitoring the battery 1520. The electronic device 1500 may update, among a plurality of degradation parameters, a parameter value of a target parameter, which may be updated to the collected measurement values. The electronic device 1500 may also update parameter values of the remaining degradation parameters through a reference parameter based on the target parameter. The electronic device 1500 may estimate the state of the battery 1520 based on the state estimation model of the battery 1520 using the updated parameter values. The one or more processors 1540 may iteratively update degradation parameter values based on the state of the battery 1520 and estimate the state of the battery 1520 based on the degradation parameter values. As described above, the one or more processors 1540 may determine the state of the battery 1520 for a corresponding estimation time point when the parameters and the estimated values of the state of the battery 1520 converge.

Here, the state estimation model of the battery 1520 may be stored in the memory 1530 of the electronic device 1500 but is not limited thereto. For example, the state estimation model (e.g., a machine learning-based model) of the battery 1520 may also be stored in an external server that is separated from the electronic device 1500. In this case, the one or more processors 1540 of the electronic device 1500 may request the estimation of the state of the battery 1520 from the external server through the communicator 1560. For example, the one or more processors 1540 may transmit updated degradation parameter values to the external server. The external server may estimate the state (e.g., an SOH value) of the battery 1520 from the received degradation parameter values, based on the machine learning-based model. The electronic device 1500 may receive the estimated state of the battery 1520 from the external server. The electronic device 1500 may, for example, request the estimation of the state of the battery 1520 from the external server that has the state estimation model of the battery 1520 whenever an update condition for a predetermined degradation parameter is satisfied.

However, examples are not limited thereto, and the electronic device 1500 may cooperate with the external server to update the parameter values for the degradation parameters and estimate the state of the battery 1520. For example, the electronic device 1500 may transmit the measurement values to the external server whenever the measurement values for the battery 1520 are collected. The external server may also select the target parameter to be updated based on the collected measurement values, calculate the parameter value of the target parameter, and iteratively estimate the state of the battery 1520. In another example, the electronic device 1500 may also update the target parameter for the estimation time point based on the measurement values collected from the battery 1520. The external server may estimate the state of the battery 1520 based on an updated target parameter value at the estimation time point and may response to the electronic device 1500. In another example, when the electronic device 1500 transmits the target parameter value to the external server, the external server may determine the remaining parameter values based on degradation trend information and may respond to the electronic device 1500. The electronic device 1500 may also estimate the state of the battery 1520 based on the parameter values received from the external server.

The one or more processors 1540 may present, on the display 1510, an SOH corresponding to the updated state of the battery 1520 and the remaining charge amount determined based on the SOH. Additionally, the one or more processors 1540 may turn off the electronic device 1500 or reduce consuming power of the electronic device 1500 when the remaining charge amount determined based on the updated state of the battery 1520 is less than a threshold charge amount. The electronic device 1500 may mitigate and/or prevent a sudden change in the remaining power presentation of the battery 1520 in the electronic device 1500 and/or unexpected shutdown of the electronic device 1500 by using a more accurately estimated state of the battery 1520 (e.g., an SOH value and/or an SOC value). Accordingly, the electronic device 1500 may provide a more predictable and stable operation of the battery 1520.

The camera 1550 may be disposed to capture a user looking at the display 1510. For example, the camera 1550 may be disposed on the same side surface as the display 1510 in the electronic device 1500 but is not limited thereto and may capture a picture and/or a video in various directions in the electronic device 1500. The electronic device 1500 may include a plurality of cameras 1550.

The communicator 1560 may include a communication circuit that performs communication with an external device. The communicator 1560 may transmit data received from the external device to the one or more processors 1540 or transmit data processed by the one or more processors 1540 to the external device.

The speaker 1570 may be disposed to output sound according to the operation of the electronic device 1500. For example, the speaker 1570 may be disposed on the same side surface as the display 1510 to output sound to a user looking at the display 1510 but is not limited thereto and may be disposed in various directions in the electronic device 1500 to output sound.

The electronic device 1500 may accurately estimate the state of the battery 1520 for each degradation state that may occur due to all users and different operation environments. In addition, since the size of an LUT required by an FG algorithm installed on the electronic device 1500 decreases, the code size and the size of a chip (e.g., an FG IC chip and a PMIC chip) decrease, thereby decreasing manufacturing cost.

The description provided with reference to FIGS. 1 through 14 may also apply to FIG. 15, and thus, a repeated description is omitted.

The processors, the memories, the displays, interfaces, batteries, and other apparatuses, devices, units, and components described herein, including descriptions with respect to respect to FIGS. 1-15, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit (ALU), a digital signal processor (DSP), a microcomputer, a programmable logic controller, a field-programmable gate array (FPGA), a programmable logic array (PLU), a microprocessor, or any other device or combination of devices that is configured to respond to and execute instructions (e.g., code or coding) in a defined manner to achieve a desired result. In one example, a processor or computer includes, or is connected to, one or more memories storing the instructions or software that are executed by the processor or computer. Hardware components implemented by a processor or computer may execute the instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both, and thus while some references may be made to a singular processor or computer, such references also are intended to refer to multiple processors or computers. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing. Thus, references to a processor herein mean processing circuitry (e.g., circuitry that includes one or more processing element(s) circuits). One or more processors comprising processing circuitry also refers to each processor comprising processing circuitry, as well as some or all of the one or more processors comprising the same processing circuitry. In addition, processors(s) and controller(s), as a non-limiting example, do not mean human processing or human control, but rather, refer to hardware components as described herein, as non-limiting examples.

The methods illustrated in, and discussed with respect to, FIGS. 1-15 that perform the operations described in this application are performed by computing hardware, for example, by one or more processors or computers, implemented as described above implementing the instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations. References to a processor, or one or more processors, as a non-limiting example, configured to perform two or more operations refers to a processor or two or more processors being configured to collectively perform all of the two or more operations, as well as a configuration with the two or more processors respectively performing any corresponding one of the two or more operations (e.g., with a respective one or more processors being configured to perform each of the two or more operations, or any respective combination of one or more processors being configured to perform any respective combination of the two or more operations). Likewise, a reference to a processor-implemented method is a reference to a method that is performed by one or more processors or other processing or computing hardware of a device or system.

The instructions or software to control computing hardware, for example, one or more processors or computers, to implement the hardware components and perform the methods as described above may be written as computer programs, code segments, or other executable instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software include higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. Thus, references herein to storage media mean storage media hardware, and does not mean to transitory media, nor a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as a multimedia card or a micro card (for example, secure digital (SD) or extreme digital (XD)), magnetic tapes, floppy disks, magneto-optical data storage devices, optical data storage devices, hard disks, solid-state disks, and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

## Claims

1. An electronic device (1500) comprising:
a battery (1520);
one or more processors (1540); and
a memory (1530) storing instructions,
wherein the instructions, when executed by the one or more processors (1540), cause the electronic device (1500) to:
store an updated parameter value of at least one target parameter (param1) selected from among a plurality of degradation parameters (111-119, param1, param2, param3) based on monitoring of the battery (1520);
determine parameter values of the other parameters (param2, param3) based on the updated parameter value of the at least one target parameter (param1);
estimate a battery state (190) of the battery (1520) based on the updated parameter value of the at least one target parameter (param1) and the determined parameter values of the other parameters (param2, param3), using a battery state estimation model (150);
update the parameter values of the other parameters (param2, param3) based on the estimated battery state (190); and
determine an updated battery state (190) based on the updated parameter value of the at least one target parameter (param1) and the updated parameter values of the other parameters (param2, param3).

2. The electronic device (1500) of claim 1, wherein the instructions, when executed, further cause the electronic device (1500) to:
obtain a measurement value for one or more of current, voltage, and temperature of the battery (1520) for each of partial operation times of the battery (1520);
identify a state of charge, SOC, section to which the battery (1520) belongs during each partial operation time; and
determine a parameter value for a degradation parameter corresponding to the identified SOC section based on the measurement value.

3. The electronic device (1500) of claim 2, wherein the instructions, when executed, further cause the electronic device (1500) to:
select the degradation parameter corresponding to the identified SOC section as the at least one target parameter (param1) in response to an accumulated time of the partial operation times in the identified SOC section exceeding a threshold time; and
determine an updated parameter value of the selected target parameter based on parameter values determined during the partial operation times corresponding to the identified SOC section.

4. The electronic device (1500) of claim 2, wherein the instructions, when executed, further cause the electronic device (1500) to:
select, as target parameters, a degradation parameter corresponding to the first SOC section and a degradation parameter corresponding to the second SOC section, in response to respective accumulated operation times in the first and second SOC sections each exceeding a threshold time.

5. The electronic device (1500) of any one of claims 1 to 4, wherein the plurality of degradation parameters (111-119, param1, param2, param3) comprises one or more of a capacity ratio of a cathode active material, anode solid electrolyte interphase, SEI, resistance, and electrode balancing.

6. The electronic device (1500) of any one of claims 1 to 5, wherein the instructions, when executed, further cause the electronic device (1500) to:
determine a parameter value of the reference parameter corresponding to the updated parameter value of the at least one target parameter (param1), based on degradation trend information indicating a relationship between the at least one target parameter (param1) and the reference parameter; and
update the determined parameter values of the other parameters (param2, param3) based on the parameter value of the reference parameter.

7. The electronic device (1500) of any one of claims 1 to 6, wherein the instructions, when executed, further cause the electronic device (1500) to determine the parameter values of the other parameters (param2, param3) corresponding to a parameter value of the reference parameter, based on degradation trend information indicating a relationship between the other parameters (param2, param3) and the reference parameter.

8. The electronic device (1500) of any one of claims 1 to 7, wherein the battery state estimation model (150) comprises one or both of an electrochemical model and a machine learning-based model.

9. The electronic device (1500) of any one of claims 1 to 8, wherein the instructions, when executed, further cause the electronic device (1500) to:
based on degradation trend information indicating a relationship between the battery state (190) and other parameters (param2, param3), update the parameter values of the other parameters (param2, param3) to a value corresponding to the estimated battery state (190).

10. The electronic device (1500) of any one of claims 1 to 9, wherein the instructions, when executed, further cause the electronic device (1500) to:
determine the updated battery state (190) for a target time point using estimation values of a battery state based on one or both of convergence of an error between the estimation values of the battery state and convergence of an error between updated values of the other parameters (param2, param3).

11. The electronic device (1500) of any one of claims 1 to 10, further comprising:
a display (1510),
wherein the instructions, when executed, further cause the electronic device (1500) to present, on the display (1510), one or both of a state of health, SOH, corresponding to the updated battery state (190) and a remaining charge amount determined based on the SOH.

12. The electronic device (1500) of any one of claims 1 to 11, wherein the instructions, when executed, further cause the electronic device (1500) to:
turn off the electronic device (1500) or reduce consuming power of the electronic device (1500) in response to a remaining charge amount determined based on the updated battery state (190) being less than a threshold charge amount.

13. A processor-implemented method, the method comprising:
storing (710) an updated parameter value of at least one target parameter (param1) selected from among a plurality of degradation parameters (111-119, param1, param2, param3) based on monitoring of a battery (1520);
determining (730) parameter values of the other parameters (param2, param3) based on the updated parameter value of the at least one target parameter (param1);
estimating (750) a battery state (190) of the battery (1520) from the updated parameter value of the at least one target parameter (param1) and the determined parameter values of the other parameters (param2, param3) using a battery state estimation model (150);
updating (770) the parameter values of the other parameters (param2, param3) based on the estimated battery state (190);
determining (790) an updated battery state (190) based on the updated parameter value of the at least one target parameter (param1) and the updated parameter values of the other parameters (param2, param3).

14. The method of claim 13, wherein the storing of the updated parameter value of the at least one target parameter (param1) comprises:
obtaining a measurement value for one or more of current, voltage, and temperature of the battery (1520) for each of partial operation times of the battery (1520);
identifying a state of charge, SOC, section corresponding to each partial operation time; and
determining a parameter value for a degradation parameter corresponding to the identified SOC section based on the measurement value.

15. A non-transitory computer-readable storage medium storing instructions that, when executed by one or more processors (1540), cause the one or more processors (1540) to perform the method of claim 13 or 14.
